# EUROPEAN PATENT APPLICATION

(11) **EP 1 146 635 A1**
(43) Date of publication of application: **17.10.2001**
(21) Application number: 01106253.6
(22) Date of filing: 14.03.2001
(51) Int. Cl.: H03F 3/26, H03F 3/60

(54) **Power amplifier**

(30) Priority: 14.03.2000 JP 2000071209
(71) Applicant: SAMSUNG ELECTRONICS CO., LTD., Suwon-City, Kyungki-do (KR)
(72) Inventor: Otani, Norihisa, Yokohama 230-0027 (JP)
(74) Representative: Grünecker, Kinkeldey, Stockmair & Schwanhäusser Anwaltssozietät

(57) **Abstract**

Disclosed is a power amplifier, which can lessen distributive and synthetic losses, minimize the size and realize a high effective signal wave thereof. The power amplifier comprises phase converters allocated at front and rear ends of the amplifying elements to include inductors employing an air core coil having a high Q value in a high frequency band, where the phase converter located at the front end of the amplifying elements distributes an input signal to an antiphase signal with the same oscillating width so as to be amplified by the amplifying elements, and the phase converter located at the rear end of the amplifying elements synthesizes and outputs the antiphase signal amplified by the amplifying elements.

## Description

The present invention relates generally to a power amplifier used in mobile communications and a cellular phone transmitter, and in particular, to a power amplifier, which can lessen distributive and synthetic losses, minimize the size and realize a high effective signal wave thereof.

A design method available for a conventional B-rated push-pull power amplifier uses a distribution integer line including a 3dB 180°-directional combiner or a 180°Wilkinson type power distributor (a phase converter). However, the B-rated amplifying circuit is an amplifying circuit that does not produce a collector current when no signal voltage is applied but produces the collector current when a signal voltage is applied. Therefore, the output under this state is only about half the amplification of the input, and cannot be used due to an excessive distortion. Instead, the output is synthesized by using two B-rated amplifying circuits and operating two upper and lower amplifying circuits in every half cycle of the input signals. This is referred to as a B-rated push-pull power amplifying circuit.

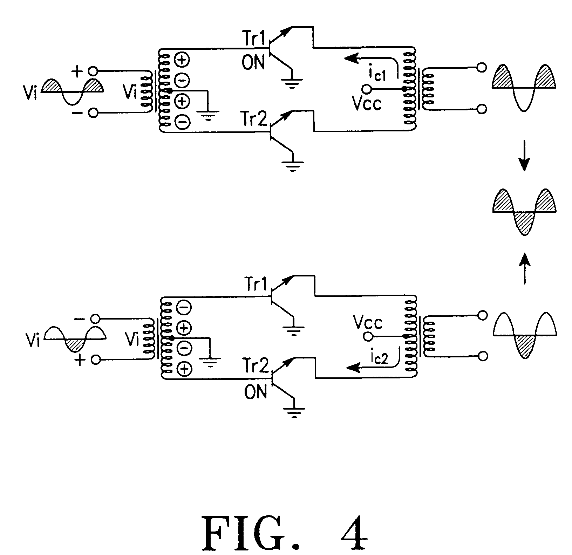

Fig. 4 is a diagram illustrating a basic construction of the conventional B-rated push-pull power amplifying circuit. When input signals are applied to a primary winding of the transformer having an intermediary tab, a voltage having a 180° mutual phase difference is generated in the secondary winding with the intermediary tab being a rotor termination. The voltage having a 180° mutual phase difference is simultaneously applied to two transistors Tr1 and Tr2.

In a half cycle where an input signal Vi is positive, a positive signal voltage is applied to a base of the transistor Tr1. The interval between the base and an emitter of the Tr1 is biased in a forward direction, and a collector current i_{c1} flows in the transistor Tr1. At this stage, a negative signal voltage is applied to a base of the transistor Tr2. As a result, the transistor Tr2 is inversely biased, and no collector current flows in the transistor Tr2. In a half cycle where the input signal Vi is positive, a negative signal voltage is applied to the base of the transistor Tr1. Therefore, no collector current flows in the transistor Tr1. At this stage, a positive signal voltage is applied to the base of the transistor Tr2, and a collector current i_{c2} flows in the transistor Tr2.

As described above, when the input signal has a half cycle of the positive signal voltage, the transistor Tr1 operates. When the input signal has a half cycle of the negative signal voltage, the transistor Tr2 operates. Therefore, a signal amplified throughout the entire cycle of the input signal can be outputted.

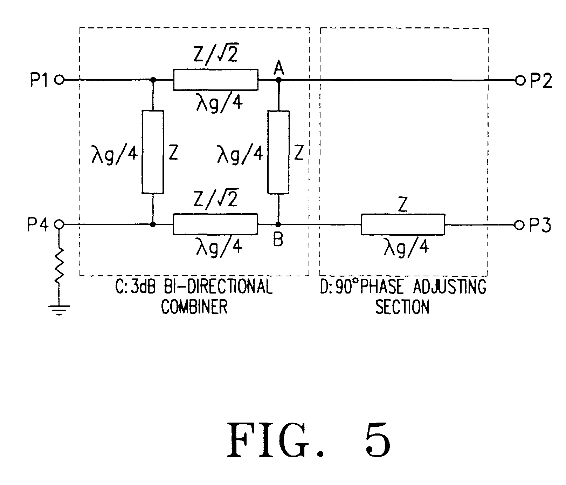

Fig. 5 is a block diagram exemplifying the construction of a 3dB 180° -directional combiner by properly combining the micro strip of 1/4 wavelength. The signal inputted from an input terminal P1 is scarcely transferred to a terminal P4 but is equally distributed to terminals P2 and P3. Moreover, point B has a phase delayed 90° in comparison with point A. Therefore, the 3dB 180°-directional combiner is constructed through a 90° phase adjusting section in D.

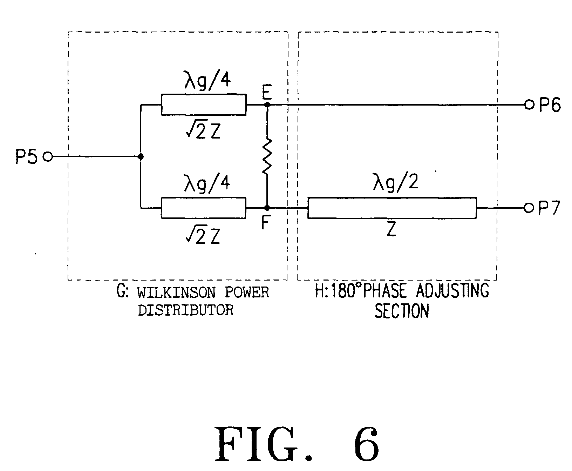

Fig. 6 is a block diagram illustrating a construction of a 180° Wilkinson type power distributor. In Fig. 6, the signal inputted through the input terminal P5 is equally distributed to terminals P6 and P7. Moreover, points E and point F are an inphase, and a 180° Wilkinson type power distributor is constructed by the 180° phase adjusting section.

The B-rated push-pull power amplifier using the conventional power distributor or a combiner has a problem that the efficiency of a signal wave frequency is decreased due to large size, an excessive distributive loss and synthetic loss thereof.

It is, therefore, the object of the present invention to provide a power amplifier of a small size with a lessened distributive loss and synthetic loss that can be used for mobile communications and a cellular phone transmitter by employing a phase converter, which uses an air core coil having a high Q value as an inductor.

According to an aspect of the present invention, there is provided an input/output matching circuit using an air core coil having a high Q value as an inductor in a high frequency bandwidth between the phase converters and power amplifying elements. Employing an air core coil as an inductor used in an input matching circuit and an output matching circuit of the power amplifying elements serves to reduce loss while enhancing efficiency.

According to another aspect of the present invention, an inductor value is varied changing a turn-pitch of the air core coil constituting the phase converters. The inductor values can be finely adjusted and doing so equalizes the distributive and synthetic losses.

The above object, features and advantages of the present invention will become more apparent from the following detailed description when taken in conjunction with the accompanying drawings, in which:
Fig. 1 is a circuit diagram illustrating a phase converter used in a power amplifier according to an embodiment of the present invention;
Fig. 2 is a circuit diagram illustrating a power amplifier according to an embodiment of the present invention;
Fig. 3 is a circuit diagram illustrating an inner construction of the input/output matching circuit in Fig. 2;
Fig. 4 is a diagram illustrating a basic construction of the conventional B-rated push-pull power amplifying circuit;
Fig. 5 is a block diagram illustrating a construction of the conventional 3dB 180° -directional combiner; and
Fig. 6 is a block diagram illustrating an inner construction of the conventional 180° Wilkinson type power distributor.

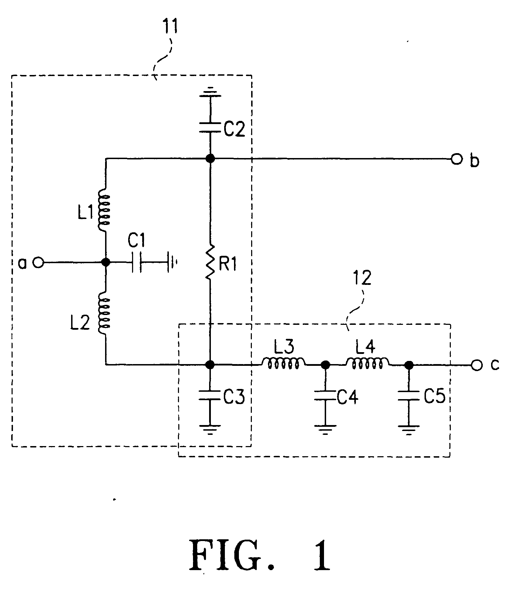

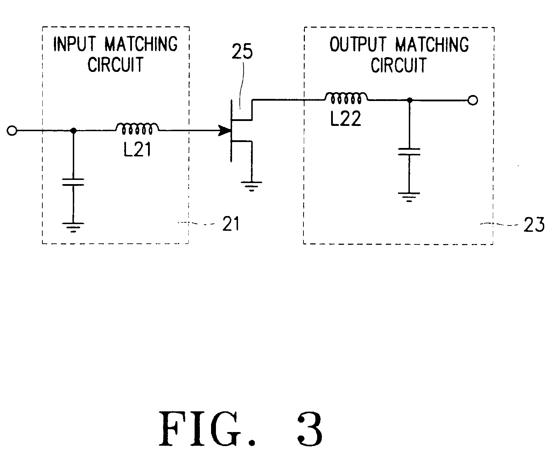

Fig. 1 is a circuit diagram illustrating a phase converter used in a power amplifier according to an embodiment of the present invention. Low frequency bandwidth ranging from UHF to several GHz mainly constitutes a wireless frequency band in a mobile communication. Therefore, lumped parameter system is used for portable usage. The concentric integer constitutes capacitors C1 to C5, inductors L1 to L4 and a resistor R1. The example illustrated here is an equivalent circuit to the 180° Wilkinson type power distributor in Fig. 3. However, an air core coil having a high Q value is used for the inductors L1 to L4. The reference numeral 11 in Fig. 1 functions as a distributing circuit, while the reference numeral 12 functions as a phase adjusting circuit. Here, the capacitor C3 alone is included in both circuits.

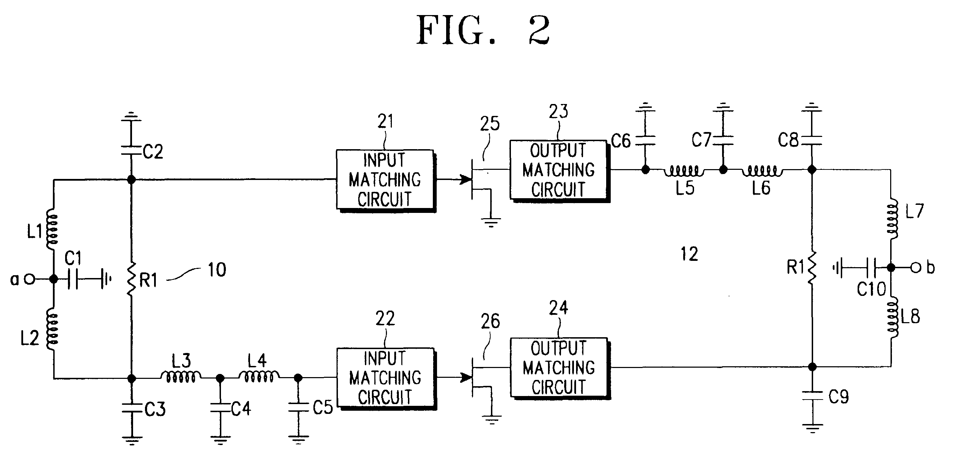

Fig. 2 is a circuit diagram illustrating a B-rated push-pull power amplifier using a phase converter according to an embodiment of the present invention. A bias circuit is omitted in the drawing. Fig. 2 illustrates a power amplifier for operating power amplifying elements 25, 26 for every half cycle of the input signal and synthesizing the output to amplify power. Phase converters 10, 20 employing an air core coil having a high Q value in a high frequency band as inductors L1 to L8 are allocated at front and rear ends of power amplifying elements 25, 26. An electric wave is transmitted through an antenna (not shown in the drawing), for example, by distributing the input signal to an antiphase signal of the same oscillating width by means of a phase converter located at the front end of the power amplifying elements 25, 26, amplifying the distributed antiphase signal by means of the power amplifying elements 25, 26, and by synthesizing and outputting the antiphase signal amplified by the power amplifying elements 25, 26 by means of the phase converter 20 located at the rear end of the power amplifying elements 25, 26.

In the above construction, employing an air core coil as inductors reduces loss in a high frequency band and minimizes the size. The inductor values can be finely adjusted by changing the turn-pitch of the air core coil.

Using chip conductors the same size as the air core coil will cause a great distributive and synthesizing loss. Thus, to lessen the loss, the size of the chip inductors needs to be enlarged, and the inductor values cannot be finely adjusted. Therefore, using the air core coil reduces the loss, and the electric wave efficiency of the signal is enhanced.

As described above, Fig. 2 illustrates a power amplifier for operating power amplifying elements 25, 26 for every half cycle of the input signal and synthesizing the output to amplify power. Allocating the phase converters 10, 20 at the front and rear ends of the power amplifying elements 25, 26, respectively, equalizes the distributive and synthesizing loss.

In the embodiment shown in Fig. 2, the signal inputted through a terminal "a" is distributed to an antiphase signal of the same oscillating width by means of the phase converter 10 located on an input side, and is amplified to power amplifying elements 25, 26. The basic wave signal amplified to the power amplifying elements 25, 26, which is an antiphase, is synthesized by the phase converter 20 and is outputted through the terminal b.

Fig. 3 is a circuit diagram illustrating an inner construction of the input matching circuit 21 and the output matching circuit 23 of the power amplifying elements. Here, the inductors L21, L22, by employing an air core coil, have advantages of reducing the loss and enhancing the electric wave efficiency of the signal.

As described above, the present invention is directed to a power amplifier for operating two power amplifying elements 25, 26 for every half cycle of an input signal, and synthesizing the output to amplify power by allocating the phase converters 10, 20 employing an air core coil having a high Q value for inductors L1 to L8, distributing the input signal to an antiphase signal with the same oscillating width by means of the phase converter 10 located at a front end, and amplifying the distributed antiphase signal by means of the power amplifying elements 25, 26. Employing an air core coil having a high Q value for a power amplifier used for mobile communications and cellular phone transmitters can minimize the distributive and synthesizing losses. In addition, the size of a phase converter can be minimized, and a highly effective B-rated push-pull power amplifier can be realized.

As described above, according to a first embodiment of the present invention, employing an air core coil having a high Q value for a power amplifier used in mobile communications and cellular phone transmitters reduces distributive and synthesizing losses. According to a second embodiment of the present invention, distributive and synthesizing losses can be reduced and electric wave efficiency can be improved by employing an air core coil for inductors used in an input matching circuit and an output matching circuit of the power amplifying elements.

While the invention has been shown and described with reference to a certain preferred embodiment thereof, it will be understood by those skilled in the art that various changes in form and details may be made therein without departing from the spirit and scope of the invention as defined by the appended claims.

## Claims

1. A power amplifier for operating two amplifying elements for every half cycle of an input signal and for synthesizing an output thereof to amplify power, comprising phase converters allocated at front and rear ends of the amplifying elements to include inductors employing an air core coil having a high Q value in a high frequency band, wherein the phase converter located at the front end of the amplifying elements distributes an input signal to an antiphase signal having the same oscillating width, the antiphase signal being amplified by the amplifying elements, and wherein the phase converter located at the rear end of the amplifying elements synthesizes and outputs the antiphase signal amplified by the amplifying elements.

2. The power amplifier of claim 1, wherein input and output matching circuits employing inductors comprising an air core coil having a high Q value in a high frequency band are allocated between the phase converters and the amplifying elements.

3. The power amplifier of claim 1 or 2, wherein the inductor values are varied by changing a turn-pitch of the air core coil comprising the phase converters.
